# EUROPÄISCHE PATENTSCHRIFT

(11) **EP 0 845 861 B1**
(45) Veröffentlichungstag und Bekanntmachung des Hinweises auf die Patenterteilung: **26.03.2003**
(21) Anmeldenummer: 97118311.6
(22) Anmeldetag: 22.10.1997
(51) Int. Cl.: H03J 9/06, G06K 11/08

(54) **Vorrichtung zur Ansteuerung eines einen Bildschirm umfassenden Geräts**
Device for controlling an apparatus that comprises a screen
Dispositif pour la commande d'un appareil qui comprend un écran

(30) Priorität: 29.11.1996 DE 19649596
(43) Veröffentlichungstag der Anmeldung: 03.06.1998
(73) Patentinhaber: Deutsche Telekom AG, 53113 Bonn (DE)
(72) Erfinder: Lorenz, Manfred, Dipl.-Ing., 53129 Bonn (DE)
(74) Vertreter: Gleiss & Grosse

(56) Entgegenhaltungen:
- US-A- 5 138 304
- US-A- 5 297 061
- US-A- 5 515 079

## Beschreibung

Die Erfindung betrifft eine Vorrichtung zur Ansteuerung eines einen Bildschirm umfassenden Geräts, vorzugsweise eines Fernsehers, das ein Bild zeilenweise aufbaut.

Im Rahmen der Multi-Media-Entwicklungen werden Lösungen diskutiert, bei denen dem heutigen Fernsehempfänger weitere Funktionen zukommen sollen. So soll das Fernsehgerät nicht nur zur Wiedergabe des heute üblichen Videotexts benutzt werden, sondern vielmehr auch als einfaches Internet-Wiedergabegerät. Bekanntlich sind die über das Internet zur Verfügung gestellten Informationen zur komfortablen Bedienung als so genannte Hypertext-Seiten aufgebaut, die ein Weiterblättern durch Aktivieren bestimmter Textbereiche beziehungsweise Bildschirmbereiche ermöglichen. Zur Bedienung solcher Hypertext-Seiten werden im Computerbereich so genannte Mäuse eingesetzt, mit deren Hilfe sich ein vom Computer auf dem Bildschirm generiertes Zeigerelement bewegen lässt und die eine Aktivierung der genannten Text- beziehungsweise Bildschirmbereiche erlauben.

Im Gegensatz zur Bedienung des Videotextsystems ist eine Bedienung solcher Hypertext-Seiten mittels bestimmter Tasten auf der Fernbedienung nicht mehr möglich.

Aus der US-PS 5,138,304 ist eine Vorrichtung zur Interaktion mit einem zeilenweise aufgebauten Bild auf einem Bildschirm eines Gerätes bekannt. Hierbei wird ein Bereich des Bildes mittels eines Lichtstiftes markiert und dieser Bereich mittels einer optischen Einrichtung unabhängig vom Gerät projiziert. Dieses projizierte Bild kann wiederum mittels eines Lichtstiftes in bestimmten Bereichen markiert werden, die durch die optische Einrichtung erfassbar sind und entsprechend bearbeitet dem den Bildschirm aufweisenden Gerät zur Anzeige zur Verfügung gestellt werden können.

Die Aufgabe der vorliegenden Erfindung besteht deshalb darin, eine Vorrichtung zu schaffen, die eine einfache Ansteuerung vergleichbar einer Computer-Maus eines einen Bildschirm umfassenden Geräts ermöglicht und in einer Fernsehfernbedienung integrierbar ist.

Diese Aufgabe wird mit einer Vorrichtung gelöst, die die Merkmale des Anspruchs 1 aufweist. Dadurch, dass die Vorrichtung eine Lichtquelle umfasst, ist eine Markierung eines bestimmten Punktes, beispielsweise eines so genannten Hyper-Links auf dem Bildschirm möglich. Markierung heißt in diesem Zusammenhang lediglich, dass die Lichtquelle auf den bestimmten Punkt gerichtet ist. Mittels eines auf diesen Punkt fokussierten Lichtdetektors wird nach Aktivierung durch den Anwender zu einem Zeitpunkt ein Signal detektiert, an dem der Elektronenstahl zur Erzeugung der Bildschirmzeile den markierten Bereich des Bildschirms durchläuft. Einer in der Vorrichtung vorgesehenen Steuereinrichtung wird das vom Lichtdetektor erzeugte Signal zugeführt und dort ausgewertet, wobei anhand des erfassten Zeitpunkts über die Bildschirm-Zeilenansteuerung auf den Bildschirmbereich des markierten Punktes geschlossen werden kann. Die Vorrichtung umfasst zwei Einheiten, von denen eine erste Einheit einer Fernbedienung des Gerätes und eine zweite Einheit dem Gerät selber zugeordnet ist, wobei die Einheiten miteinander im Bedarfsfalle kommunizieren.

Es ist also auf einfache Weise möglich, die bekannte Fernbedienung als "Mausersatz" auszubilden, so daß auf den Einsatz einer neben der Fernbedienung zusätzlichen Maus verzichtet werden kann.

Vorzugsweise ist die Lichtquelle als Laser ausgebildet, der den Vorteil einer guten Fokussierbarkeit besitzt und damit eine genaue Markierung gewährleistet.

In einer vorteilhaften Ausgestaltung der Erfindung ist dem Lichtdetektor eine Fokussiereinheit zugeordnet, die eine störungsfreie Erfassung der Bildschirmzeilen ermöglicht. Vorzugsweise wird die Fokussiereinheit über die Steuereinrichtung eingestellt, wobei eine Kopplung mit einer Fokussierung der Lichtquelle vorteilhaft ist.

Weitere vorteilhafte Ausgestaltungen der Erfindung ergeben sich aus den übrigen Unteransprüchen.

Die Erfindung wird nun anhand eines Ausführungsbeispiels mit Bezug auf die Zeichnungen näher erläutert. Dabei zeigen:
- Figur 1: ein Blockschaltbild der erfindungsgemäßen Vorrichtung, und
- Figur 2: eine schematische Darstellung zur Erläuterung der Arbeitsweise der erfindungsgemäßen Vorrichtung.

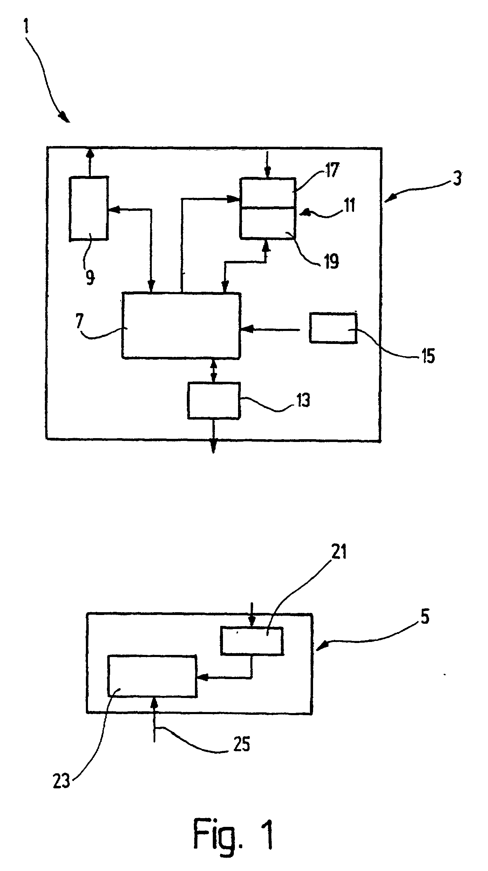

In Figur 1 ist funktionell eine Vorrichtung 1 zur Ansteuerung eines Fernsehgeräts dargestellt. Sie umfaßt eine erste Einheit 3 und eine zweite Einheit 5, wobei die erste Einheit Bestandteil einer Fernbedienung und die zweite Einheit Bestandteil des Bildschirmgeräts ist.

Die erste Einheit 3 weist eine Steuereinrichtung 7 auf, die einem als Lichtquelle dienenden Laser 9, einer Empfangseinrichtung 11 und einem Sender 13 zugeordnet ist. Des weiteren ist mit der Steuereinrichtung 7 ein Bedienungselement 15, beispielsweise ein auf der Fernbedienung angebrachter Taster vorbunden.

Mit dem Laser 9 ist bei Bedarf, beispielsweise nach Bedienung eines bestimmten Schalters auf der Fernbedienung ein Lichtstrahl erzeugbar, der punktförmig oder flächig, zum Beispiel als Kreis ausgebildet ist. Zur Erhöhung der Erkennbarkeit ist es jedoch auch denkbar, mit dem Lichtstrahl beispielsweise einen Zeiger zu projezieren.

Die Lichtempfangseinrichtung 11 umfaßt eine Fokussiereinheit 17 und einen nachgeordneten Fotosensor 19. Dieser ist zur Erfassung des gesamten vom Bildschirm ausgestrahlten Spektralbereichs ausgelegt. Es ist jedoch auch denkbar, einen Fotosensor 19 zu verwenden, der nur bestimmte Spektralfarben erfaßt.

Die Fokussiereinheit dient dazu, den vom Fotosensor zu erfassenden Bereich hinsichtlich dessen Größe festzulegen beziehungsweise einzustellen.

Bei dem Sender 13 handelt es sich um die üblicherweise in Fernbedienungen verwendeten Infrarotsender, wobei jedoch auch andere Übertragungsmedien, beispielsweise Ultraschall denkbar sind. Der Sender 13 wirkt mit einem entsprechenden Empfänger 21 zusammen, der Teil der zweiten Einheit 5 ist. Der Sender 21 ist mit einer Auswerteeinrichtung 23 verbunden, die die empfangenen Signale auswertet und zum Beispiel die Nummer der abzurufenden Seite an den entsprechenden Teil eines Videotextdecorders oder eine IP-Adresse (Internet Protocol) an eine Rechnereinheit sendet. Zur Auswertung werden der Auswerteeinrichtung 23 darüber hinaus über eine Leitung 25 Daten von einer nicht gezeigten Zeilenansteuerungsvorrichtung zugeführt, die die zeilenweise Führung des Elektronenstrahls steuert.

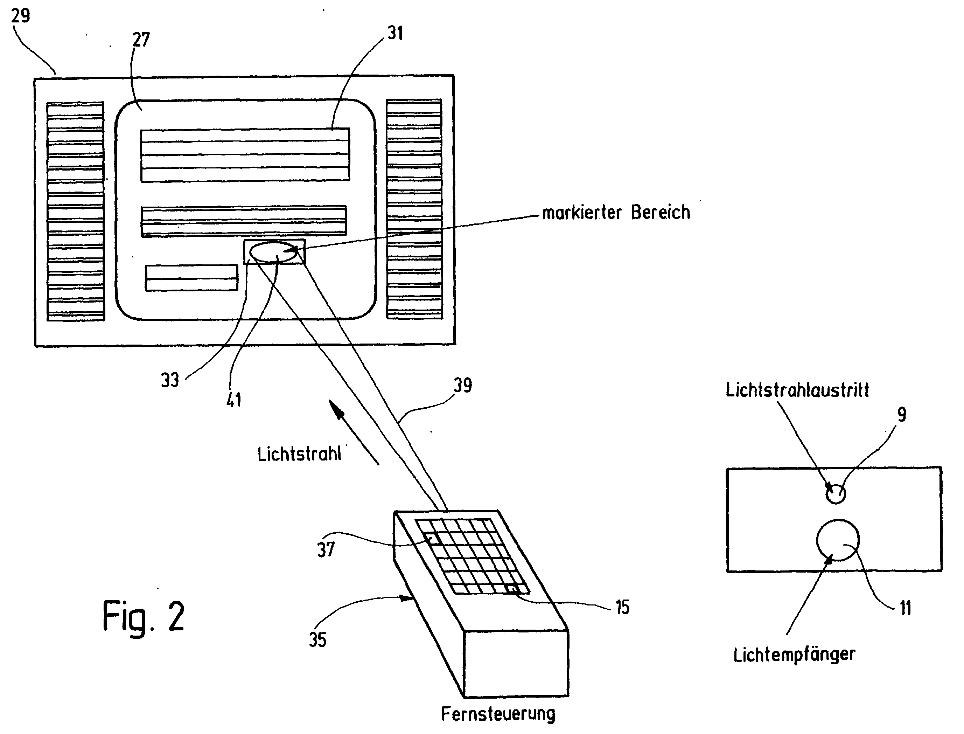

Mit Bezug auf die Figur 2 wird nun die Funktionsweise der Vorrichtung 1 erläutert.

Ausgangspunkt ist eine auf einem Bildschirm 27 eines Fernsehgeräts 29 dargestellte Informationsseite 31, die in einem Bereich 33 ein als Hyper-Link markiertes Stichwort enthält. Durch Aktivieren dieses Bereichs 33 ist es möglich, zu diesem Stichwort passende Informationsseiten aufzurufen, wobei die zum Aufruf notwendige IP-Adressen in der Auswerteeinrichtung hinterlegt sind. Die Aktivierung dieses Bereichs erfolgt mit einer Fernbedienung 35, die die vorgenannte erste Einheit 3 umfaßt. Dazu muß zunächst der Laser 9 beispielsweise durch Betätigen eines Schalters 37 eingeschaltet werden, so daß ein Lichtstrahl 39 erzeugt wird. Der Anwender ist nun in der Lage, durch Bewegen der Fernsteuerung 35 einen bestimmten Bildschirmbereich 41 anzuleuchten und damit zu markieren, wobei der Fotosensor so angeordnet ist, daß er diesen Bildschirmbereich erfaßt. Nachdem der gewünschte Bereich markiert ist, der Fotosensor also darauf gerichtet ist, betätigt der Anwender den Taster 15 auf der Fernbedienung 35, was einem "Mausklick" bei der Computermaus entspricht.

Die Steuereinrichtung 7 wartet nun auf ein Signal des Fotosensors 19, der mittels der Fokussiereinheit 17 auf den markierten Bereich 41 fokussiert ist. Der Fotosensor erzeugt dann ein Signal, wenn der bei Fernsehgeräten zum Aufbau des Bildes benutzte Elektronenstrahl den markierten Bereich 41 durchläuft. Die Steuereinrichtung 7 sendet daraufhin über den Sender 13 ein Signal ab, das vom Empfänger 21 empfangen und an die Auswerteeinrichtung 23 weitergeleitet wird. Die Auswerteeinrichtung 23 berechnet nun anhand der von der Bildschirmansteuerung übermittelten Daten den genauen Ort des vom Elektronenstrahl abgetasteten Bildschirmbereichs zum Zeitpunkt des vom Fotosensor 19 erzeugten Signals.

Damit ist es also möglich, einen bestimmten Bildschirmbereich zu markieren und durch Bedienung des Tasters 15 zu aktivieren, so daß eine bestimmte Funktion ausgeführt wird.. Durch entsprechende Ausgestaltung der Auswerteeinrichtung 23, auf die an dieser Stelle nicht näher eingegangen werden soll, läßt sich anhand des berechneten Orts des markierten Bereichs die auszuführende Funktion bestimmen, wie das Anzeigen einer weiteren Informationsseite zu einem bestimmten Stichwort.

Um eine Beeinflussung des Lichtdetektors durch den Laserstrahl zu vermeiden, wird vorzugsweise der Laserstrahl nach der Betätigung des Tasters für eine bestimmte Zeitdauer ausgeblendet beziehungsweise abgeschaltet. Bei üblichen 50 Halbbildern pro Sekunde genügt eine 1/25 Sekunde als Zeitdauer.

Besonders vorteilhaft ist der Einsatz eines auf eine bestimmte Spektralfarbe (rot, grün, blau) ausgelegten Fotosensors 19. Da sich die Hyper-Links in ihrer Farbe im allgemeinen vom übrigen Text unterscheiden, läßt sich durch entsprechende Wahl der Farbempfindlichkeit des Fotosensors eine Verbesserung der Erkennung erreichen. Außerdem ist der durch den Laser hervorgerufene Störeffekt (sofern er nicht ausgeblendet wird) vermeidbar, wenn der Laserstrahl eine andere Spektralfarbe besitzt. Im übrigen kann mit Hilfe des farbempfindlichen Fotosensors auf unterschiedliche Teile des markierten Bereichs reagiert werden. Darüber hinaus ist auch eine bessere Unterscheidung bei ungenauer, beispielsweise durch Zittern hervorgerufenen Erfassung des markierten Bereichs möglich. Außerdem kann mit einem monochromen Lichtstrahl eine weitere Selektion durch farbliche Addition der Spektralfarben von Lichtstrahl und Bildschirmpunkt erzielt werden.

Eine weitere Möglichkeit, den Störeinfluß des Lasers auf die Erfassung des markierten Bereichs zu vermindern, besteht darin, den Laserstrahl als Ring zu projezieren, wobei der Lichtdetektor dann in den laserfreien mittleren Ringbereich fokussiert wird.

Eine weitere vorteilhafte Weiterbildung besteht darin, dem Laser ebenfalls eine Fokussieroptik zuzuordnen, wobei deren Steuerung abhängig von der Steuerung der Fokussiereinheit des Lichtdetektors erfolgt. Hiemit läßt sich die Größe der Projektion auf den Bildschirm, die unter anderem von der Entfernung Fernbedienung-Bildschirm abhängt, einstellen.

## Patentansprüche

1. Vorrichtung zur Ansteuerung eines einen Bildschirm umfassenden Geräts, das ein Bild zeilenweise aufbaut, mit einer Lichtquelle (9) zur Markierung eines bestimmten Bereichs (41) auf dem Bildschirm (27), einem Lichtdetektor (11) zur optischen Erfassung einer Bildschirmzeile im Bereich des markierten Bereichs (41), einem Schalter (15) zur Auslösung einer Ansteuerung und einer Auswerteeinrichtung (23), die anhand eines vom Lichtdetektor (11) zugeführten Signals und einer Zeilenansteuerung des Bildschirms den Ort des markierten Bereichs (41) auf dem Bildschirm (27) ermittelt, wobei eine erste Einheit (3) der Vorrichtung, die die Lichtquelle (9), den Lichtdetektor (11) und den Schalter (15) umfasst, Teil einer Fernbedienung (35) für das Gerät (29) ist und eine zweite Einheit (5) der Vorrichtung, die die Auswerteeinrichtung (23) umfasst, dem Gerät (29) zugeordnet ist und durch ein entsprechendes Signal von der Fernbedienung (35) aktivierbar ist.

2. Vorrichtung nach Anspruch 1, **dadurch gekennzeichnet, dass** die Lichtquelle (9) ein Laser ist.

3. Vorrichtung nach Anspruch 1 oder 2, **dadurch gekennzeichnet, dass** der Lichtdetektor (11) eine Fokussiereinheit (17) umfasst.

4. Vorrichtung nach einem der vorhergehenden Ansprüche, **dadurch gekennzeichnet, dass** der Lichtdetektor (11) einen Fotosensor (19) aufweist.

5. Vorrichtung nach Anspruch 4, **dadurch gekennzeichnet, dass** der Fotosensor (19) auf eine Spektralfarbe ausgelegt ist.

6. Vorrichtung nach einem der vorhergehenden Ansprüche, **dadurch gekennzeichnet, dass** zur Aktivierung der Lichtquelle (9) ein Schalter (37) vorgesehen ist.

7. Vorrichtung nach einem der vorhergehenden Ansprüche, **dadurch gekennzeichnet, dass** die Lichtquelle (9) während der Auslösung einer Ansteuerung für eine bestimmte Zeitdauer ausgeblendet ist.

8. Vorrichtung nach Anspruch 3, **dadurch gekennzeichnet, dass** der Lichtquelle eine Fokussiereinheit zugeordnet ist, die mit der Fokussiereinheit (17) des Lichtdetektors (11) gekoppelt ist.

9. Vorrichtung nach einem der vorhergehenden Ansprüche, **dadurch gekennzeichnet, dass** das den Bildschirm umfassende Gerät ein Fernseher ist.

## Claims

1. Device for controlling an apparatus comprising a screen, said apparatus building up an image line by line, with a light source (9) for marking a certain region (41) on the screen (27), a light detector (11) for the optical detection of a screen line in the region of the marked region (41), a switch (15) for triggering a control and an evaluation means (23) which determines the location of the marked region (41) on the screen (27) on the basis of a signal from the light detector (11) and on the basis of a line control of the screen, wherein a first unit (3) of the device, comprising the light source (9), the light detector (11) and the switch (15), is part of a remote control (35) for the apparatus (29) and a second unit (5) of the device, comprising the evaluation means (23), is associated with the apparatus (29) and is able to be activated by a corresponding signal from the remote control (35).

2. Device according to claim 1, **characterized in that** the light source (9) is a laser.

3. Device according to claim 1 or 2, **characterized in that** the light detector (11) comprises a focusing unit (17).

4. Device according to any one of the preceding claims, **characterized in that** the light detector (11) comprises a photosensor (19).

5. Device according to claim 4, **characterized in that** the photosensor (19) is designed for a spectral colour.

6. Device according to any one of the preceding claims, **characterized in that** a switch (37) is provided for activating the light source (9).

7. Device according to any one of the preceding claims, **characterized in that** the light source (9) is blocked out for a certain period of time during the triggering of a control.

8. Device according to claim 3, **characterized in that** the light source is associated with a focusing unit which is coupled to the focusing unit (17) of the light detector (11).

9. Device according to any one of the preceding claims, **characterized in that** the apparatus comprising the screen is a television set.

## Revendications

1. Equipement pour la commande d'accès à un appareil comprenant un écran qui crée, ligne par ligne, une image, avec une source de lumière (9) pour marquer une zone déterminée (41) sur l'écran (27), un détecteur de lumière (11) pour la saisie optique d'une ligne d'écran dans la zone marquée (41), un commutateur (15) pour l'amorçage d'une commande d'accès et un dispositif d'analyse (23) qui identifie sur l'écran (27) l'emplacement de la zone marquée (41) à l'aide d'un signal apporté par le détecteur de lumière (11) et d'une sélection de ligne sur l'écran, une première unité (3) de l'équipement, comprenant la source de lumière (9), le détecteur de lumière (11) et le commutateur (15), faisant partie d'une télécommande (35) pour l'appareil (29) et une deuxième unité (5) de l'équipement, comprenant le dispositif d'analyse (23), étant assignée à l'appareil (29) et pouvant être activée par un signal idoine par la télécommande (35).

2. Equipement selon la revendication 1, **caractérisé en ce que** la source de lumière (9) est un laser.

3. Equipement selon la revendication 1 ou 2, **caractérisé en ce que** le détecteur de lumière (11) comprend une unité de focalisation (17).

4. Equipement selon l'une des revendications précédentes, **caractérisé en ce que** le détecteur de lumière (11) présente un photocapteur (19).

5. Equipement selon la revendication 4, **caractérisé en ce que** le photocapteur (19) est réglé sur une couleur spectrale.

6. Equipement selon l'une des revendications précédentes, **caractérisé en ce qu'**un commutateur (37) est prévu pour activer la source de lumière (9).

7. Equipement selon l'une des revendications précédentes, **caractérisé en ce que** la source de lumière (9) est éteinte pour une durée déterminée pendant l'amorçage d'une commande d'accès.

8. Equipement selon la revendication 3, **caractérisé en ce que** la source de lumière se voit assigner une unité de focalisation couplée avec l'unité de focalisation (17) du détecteur de lumière (11).

9. Equipement selon l'une des revendications précédentes, **caractérisé en ce que** l'appareil comprenant l'écran est un téléviseur.
